(19)

Europäisches
Patentamt
European
Patent Office
Office européen
des brevets

(11) **EP 2 426 739 A1**

(12) **EUROPEAN PATENT APPLICATION**
published in accordance with Art. 153(4) EPC

(43) Date of publication:
**07.03.2012 Bulletin 2012/10**

(21) Application number: **10780380.1**

(22) Date of filing: **16.04.2010**

(51) Int Cl.:
**H01L 31/10** *(2006.01)* **H01L 31/0264** *(2006.01)*

(86) International application number:
**PCT/JP2010/056865**

(87) International publication number:
**WO 2010/137423 (02.12.2010 Gazette 2010/48)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **25.05.2009 JP 2009125195**

(71) Applicant: **Japan Science and Technology Agency
Saitama 332-0012 (JP)**

(72) Inventors:
• **KOMIYAMA, Susumu**
  **Tokyo 154-0016 (JP)**
• **NICKELS, Patrick**
  **Tokyo 167-0013 (JP)**
• **UEDA, Takeji**
  **Tokyo 154-0017 (JP)**

(74) Representative: **Hofmann, Ralf U. et al
Hofmann & Fechner
Patentanwälte
Egelseestrasse 65a
Postfach 61
6806 Feldkirch (AT)**

(54) **INFRARED SENSOR**

(57) Provided is an infrared light detector 100 wherein a light coupling mechanism 110 is configured by a metal thin film or metal thin plate in which a plurality of windows apart from each other are formed. Each of the windows is formed by multangular shapes in which a part of the internal angles are obtuse angles. The plurality of windows are periodically arrayed in postures having translational symmetry in at least two directions. The array cycle p of the plurality of windows are set according to a wavelength λ' of the infrared light of a substrate including a first electronic layer 110 so as to fall within a range with reference to a value at which a perpendicular oscillating electric field component in a first electronic region 10 indicates a peak value.

FIG.3 (a)

**EP 2 426 739 A1**

**(Cont. next page)**

FIG.3 (b)

**Description**

FIELD OF THE INVENTION

The present invention relates to an infrared light detector.

DESCRIPTION OF THE RELATED ART

There has been proposed a high sensitivity infrared light detector having a CSIP (Charge Sensitive Infrared Phototransistor) as an element by the inventors of the present application (for example, refer to published PCT international application WO2006/006469A (Patent Document 1), "Infrared phototransistor using capacitively coupled two-dimensional electron gas layers (An et al.)" Appl. Phys. Lett. 86, 172106(2005), "A sensitive double quantum well infrared photoresistor (An et al.)" J. Appl. Phys., 100, 044509(2006) (Non-Patent Literature 1)).

According to this infrared light detector, infrared light is concentrated on a two-dimensional electronic layer (floating gate), such as a quantum well or the like which is electrically isolated from the ambient by a microstrip antenna or a metal patch array or the like. This generates a perpendicular oscillating electric field in the isolated two-dimensional electronic layer. Then, an electron in the isolated two-dimensional electronic layer is excited by the oscillating electric field and transitioned from a ground sub-band to an excited sub-band, and then escapes from the isolated two-dimensional electronic layer to a conduction channel or the like in a charge sensitive transistor disposed right below the isolated two-dimensional electronic layer. Thereby, the isolated two-dimensional electronic layer becomes positively charged. As a result, an electric conductivity between the source-drain of the CSIP increases.

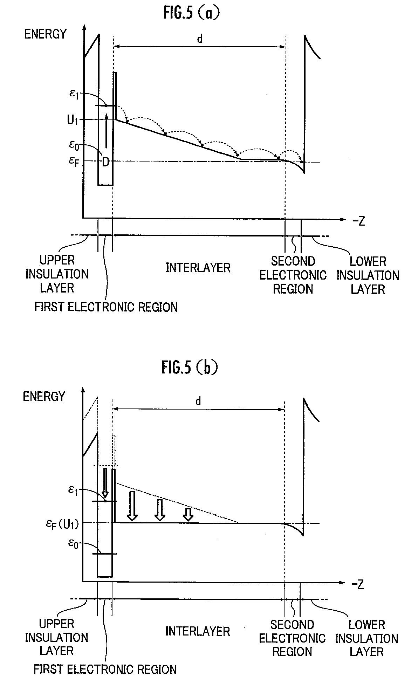

More specifically, when the infrared light is introduced into the infrared light detector, an oscillating electric field is formed in a direction perpendicular to a first electronic region (Z direction) by a light coupling mechanism. By this oscillating electric field, electrons are transitioned from the ground sub-band (electron energy level $\varepsilon_0$) to the excited sub-band of the quantum well in the first electronic region as indicated by an upward arrow in figure 5(a). The electrons transitioned to the excited sub-band escape from a potential barrier of the quantum well in the tunneling process as indicated by a dashed arrow in figure 5(a). In order to enable the tunneling escape process, a potential $U_1$ of the interlayer on the quantum well side is set lower than an electron energy level $\varepsilon_1$ of the excited sub-band and higher than a Fermi energy $\varepsilon_F$ (electrochemical potential) in an opposed region of the conduction channel in order to acquire energy gradient of the interlayer. Therefore, the electrons which escape from the excited sub-band in the tunneling process flow into the conduction channel according to the energy gradient of the interlayer, especially into the region opposed to the first electronic region (which corresponds to "a second electronic region" of the present invention). Accordingly, the first electronic region is positively charged or ionized. That is, the first electronic region and the second electronic region function as a capacitor sandwiching the interlayer in a disconnected status, thereby storing positive electric charge in the first electronic region.

Then, as a result of continuously introducing the infrared light into the infrared light detector, since the number of electrons escaping from the first electronic region to the conduction channel continuously increases as described above, the amount of the electric charge in the first electronic region continuously increases correspondingly. Moreover, as the amount of electric charge in the first electronic region increases, the electric conductivity of the conduction channel increases. Therefore, by detecting the change of electric conductivity of the conduction channel, it is able to detect an integral value of the incident infrared light with high sensitivity.

Accordingly, since the change of the electric conductivity between the source-drain of the CSIP is saturated in a relatively short time from starting to detect the infrared light, the infrared light sensitivity will have limitations.

More specifically, by the increase of the amount of positive electric charge $\Delta Q$ in the first electronic region, the electron energy level $\varepsilon_1$ of the excited sub-band in the first electronic region decreases, and the difference from the Fermi level $\varepsilon_F$ (electrochemical potential) of the second electronic region in the conduction channel where the electrons mainly escape to, becomes smaller. For example, when the amount of positive electric charge $\Delta Q$ in the first electronic region reaches $\Delta Q_{sat} = (\varepsilon_1 - U_1)C/e$, a state in which the energy high-low difference in the interlayer is large as shown in figure 5(a), becomes a state in which the energy high-low difference in the interlayer disappears as shown in figure 5 (b). Here, $C = \varepsilon/d$ represents an electrical capacitance per unit area formed by the first electronic region and the second electronic region in the conduction channel, d denotes a distance between a first electronic layer and a second electronic layer, and $\varepsilon$ denotes an electric permittivity of the intermediate region. Then, not only the excited electrons escape from the first electronic region to the conduction channel, but also the electrons which are thermally excited in the conduction channel are able to backflow to the first electronic region, and therefore net escape does not occur. As a result, the increase of the amount of the electric charge in the first electronic region stops and saturates. Then, even though the infrared light is further introduced, the electric conductivity of the conduction channel will not change any more, and infrared light detection based on the change rate of the electric conductivity can not be continued.

In this regard, the inventors of the present application have proposed an infrared light detector with higher sensitivity which was modified to solve the above problem (Refer to Japanese patent laid-open publication number 2008-205106 (Patent Document 2) and "Reset Operation of Quantum-Well Infrared Phototransistor (zhenghua An, TakejiUeda, Kazuhiko Hirakawa and Susumu Komiyama), IEEE Transactions on Electron Devices, Vol.54, 1776-1780 (2007) (Non-Patent Literature 2)).

According to this infrared light detector, the isolated two-dimensional electronic region is electrically connected to the conduction channel of the source, drain, or between the source-drain via a reset gate, before the change of the electric conductivity between the source-drain saturates. Accordingly, electrons flow into the first electronic region from an outer electron system and these electrons are coupled to positive electric charge, thereby resetting the amount of electric charge of the first electronic region to 0 promptly and a value of the electric conductivity is returned to an initial value before the change, and the energy diagram returns to the state shown in figure 5(a) from the state shown in figure 5(b). That is, the energy level $\varepsilon_1$ of the excited sub-band in the first electronic region 10 returns to a state high enough such that the electrons transitioned to the excited sub-band may flow out from the first electronic region 10 to the second electronic layer 104 easily or at a high probability.

Thereafter, the first electronic region is switched from a connected status to a disconnected status, and therefore returns to a state in which the electric charge of the first electronic region 10 proceeds by the escape of the electrons excited in the excited sub-band from the isolated two-dimensional electronic region as described above. Therefore, it is able to detect infrared light repeatedly and cumulatively, thereby enabling the improvement of the infrared light sensitivity.

SUMMARY OF THE INVENTION

PROBLEMS TO BE SOLVED BY THE INVENTION

However, according to the conventional patch antenna or the like, the quantum efficiency defined as a ratio of electron outflow rate from the isolatd two-dimensional electronic layer with respect to a photon incidence rate, is low such as 1 to 2 %. This can be improved.

It is therefore an object of the present invention to solve the above mentioned problem and to provide an infrared light detector capable of further improving the infrared light sensitivity.

MEANS TO SOLVE THE PROBLEM

The present invention is related to an infrared light detector having a first electronic region configured to be capable of being maintained in an electrically isolated status in a first electronic layer which is a two-dimensional electronic layer; a light coupling mechanism configured to excite an electron by generating an oscillating electric field component perpendicular to the first electronic region according to an incident infrared light, and allowing the electron to transit between sub-bands in a quantum well formed in the first electronic region; a conduction channel in a second electronic layer which is a two-dimensional electronic layer disposed parallel to the first electronic layer via an intermediate insulation layer, whose electric conductivity varies as a result of the electron excited by the light coupling mechanism flowing out of the first electronic region; a status controlling mechanism configured to perform switching between a disconnected status in which the first electronic region is electrically disconnected from an outer electron system and a connected status in which the first electronic region is electrically connected to the outer electron system; and which detects the incident infrared light by detecting a variation of the electric conductivity with respect to a specific direction of the conduction channel.

The infrared light detector of the present invention for solving the above problem is **characterized in that** the light coupling mechanism is composed of a metal thin film or a metal thin plate on which a plurality of windows apart from each other are formed, the plurality of windows being arrayed periodically in a posture having translational symmetry for at least two directions, and an array cycle p of the plurality of windows is set according to a wavelength $\lambda$' of the incident infrared light of a substrate including the first electronic layer so as to fall within a first specific range with reference to a value at which the perpendicular oscillating electric field component in the first electronic region indicates a peak.

According to the infrared light detector of the present invention, it is able to effectively generate the electric field component perpendicular to the first electronic layer according to the incident infrared light by the metal thin film composing the light coupling mechanism on which the plurality of windows are formed. By this, the quantum efficiency is significantly enhanced, and as a result, remarkably improving the detection accuracy of the infrared light.

It is preferable that the first specific range is 0.68 to 1.25 $\lambda$'. It is also preferable that the first specific range is 0.80 to 1.02 $\lambda$'.

With respect to an array direction of the plurality of windows, a size I of each window may be set according to the array cycle p of the plurality of windows so as to fall within a second specific range with reference to a value at which the perpendicular oscillating electric field component in the first electronic region indicates a peak. It is preferable that the second specific range is 0.50 to 0.80 p.

Each of the windows may be formed in a multangular shape in which a part of internal angles are obtuse angles. Each of the plurality of windows also may be formed in a shape such as a plurality of line segments having an angle at four corners crossing each other. It is also acceptable to form each of the plurality of windows in a cross-like shape such as two of the plurality of line segments having an angle at four corners crossing orthogonally.

BRIEF DESCRIPTION OF THE DRAWINGS

Fig. 1 is a structural explanatory diagram illustrating a main part of an infrared light detector according to the present invention;

Fig. 2(a) is a cross-section diagram of line IIa-IIa of Fig.1, and Fig. 2(b) is a cross-section diagram of line IIb-IIb of Fig. 1;

Fig. 3 is a structural explanatory diagram illustrating a light coupling mechanism of the infrared light detector of the present invention;

Fig. 4 is an explanatory schematic diagram of the infrared light detector;

Fig. 5 is a regional energy diagram of the infrared light detector;

Fig. 6 is an explanatory diagram regarding a reset of the infrared light detector;

Fig. 7 is a total energy diagram of the infrared light detector of the present invention;

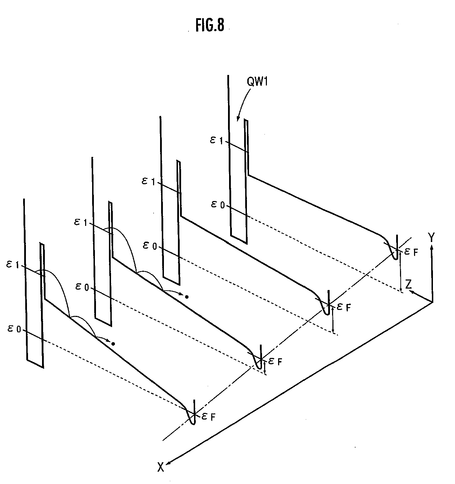

Fig. 8 is a total energy diagram of a conventional infrared light detector;

Fig. 9 is an explanatory diagram of an experiment result regarding an infrared light detection sensitivity of the infrared light detector of the present invention;

Fig. 10 is an explanatory diagram regarding an experiment result of the infrared light detection sensitivity of the infrared light detector of the present invention;

Fig. 11 is an explanatory diagram regarding an experiment result of a quantum efficiency of the infrared light detector of the present invention;

Fig. 12 is an explanatory diagram regarding an experiment result of a quantum efficiency of the infrared light detector of the present invention;

Fig. 13 is an explanatory diagram regarding a simulation calculation result of an electric field z component in the first electronic region of the infrared light detector;

Fig. 14 is an explanatory diagram regarding a simulation calculation result of an electric field z component in the first electronic region of the infrared light detector; and

Fig. 15 is a structural explanatory diagram illustrating a light coupling mechanism of an infrared light detector according to another embodiment of the present invention.

DETAILED DESCRIPTION OF THE PREFERRED EMBODIMENTS

An embodiment of an infrared light detector according to the present invention will be described with reference to the drawings.

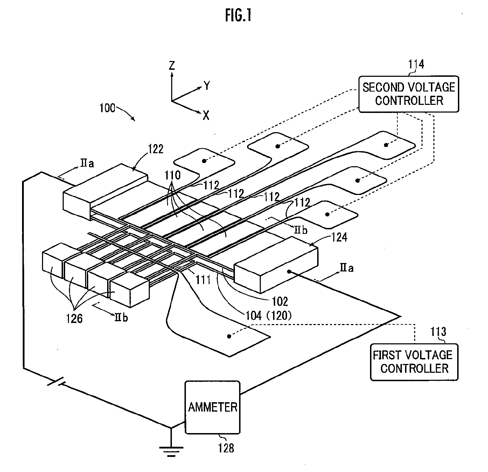

A structure of the infrared light detector will be described first. The infrared light detector 100 illustrated in Fig. 1 is provided with a first electronic layer 102, a second electronic layer 104, a light coupling mechanism (an exciting mechanism) 110, a first gate electrode 111, a second gate electrode 112, a first voltage controller (or a pulse generator) 113, and a second voltage controller 114. For descriptive convenience, X, Y and Z axes are defined as illustrated in Fig. 1.

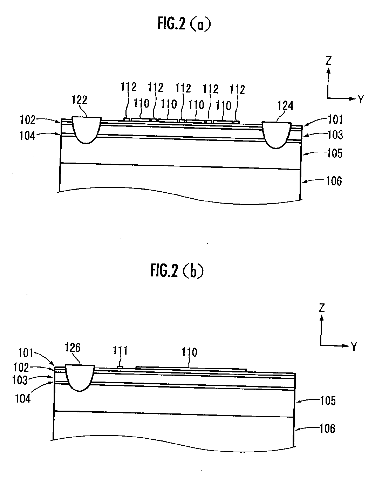

For example, the infrared light detector 100 is made of a multilayered heteroepitaxial growth semi-conductor substrate disclosed in Patent Document 1 and has a layered structure as illustrated in Fig. 2(a) and Fig. 2(b).

The substrate is of a heterojunction structure including in order from the top an upper insulation layer (GaAs layer+ Si-$Al_{0.3}Ga_{0.7}As$ layer) 101, a first electronic layer (GaAs layer) 102 as one two-dimensional electronic layer, an interlayer ($Al_xGa_{1-x}As$ layer) 103, a second electronic layer (GaAs layer) 104 as another two-dimensional electronic layer disposed parallel to the one two-dimensional electronic layer, a lower insulation layer ($Al_{0.3}Ga_{0.7}As$ layer+ Si-$Al_{0.3}Ga_{0.7}As$ layer+ $Al_{0.3}Ga_{0.7}As$ layer) 105 and an n-type GaAs substrate 106. The composition ratio x in the interlayer 103 is adjusted so as to form an energy diagram in the depth direction (-Z direction) of the substrate on an early phase of a disconnected status, as illustrated in Fig. 5(a).

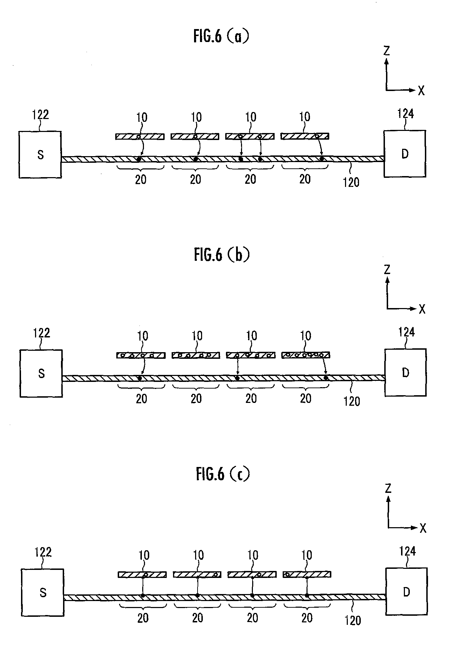

As illustrated in Fig. 1, the first electronic layer 102 is formed to have a shape having four linear regions extending from a central portion of a belt-like region extending in the X direction. The first electronic layer 102 has a thickness of approximately 10 nm and is formed at a depth position of approximately 100 nm from the surface of the substrate. A plurality of first electronic regions (isolated two-dimensional electronic region) 10 which are electrically disconnected, are arranged in the X direction and formed in the first electronic layer 102 as schematically shown in Fig. 6(a). In each of the plurality of first electronic regions 10, a quantum well is formed in the -Z direction in an early phase of the disconnected status, as shown in Fig. 5(a), and there is formed a ground sub-band (energy level of $\varepsilon_0$) and an excited

sub-band (energy level of $\varepsilon_1$ ($>\varepsilon_0$)).

The second electronic layer 104 is formed approximately the same shape as the first electronic layer 102 and is disposed in the same posture as the first electronic layer 102 underneath the first electronic layer 102. That is, the second electronic layer 104 is formed in a shape such as the first electronic layer 102 being directly projected downward (-Z direction). In the second electronic layer 104, there is formed a conduction channel 120 which extends in the X direction and opposes the plurality of first electronic regions 10 in the Z direction, as schematically shown in Fig. 6(a). The conduction channel 120 (more precisely, each of a second electronic regions 20 opposing each of the first electronic regions 10) has an energy level lower than that of the excited sub-band in the quantum well formed in the first electronic region 10 in the -Z direction in the early phase of the disconnected status, as illustrated in Fig. 5(a). Also, in this case, the Fermi level (electrochemical potential) of each of the second electronic regions 20 is equal to the Fermi level (electrochemical potential) of each of the corresponding first electronic regions 10.

The first electronic layer 102 and the second electronic layer 104 are connected by a first ohmic contact (drain electrode) 122 at the end region of one side in the X direction and by a second ohmic contact (source electrode) 124 at the end region of the other side in the X direction. A current or an electric conductivity of the conduction channel 120 in the X direction (a specific direction) is measured by an ammeter 128 connected to the first ohmic contact 122 and the second ohmic contact 124. Furthermore, the first electronic layer 102 and the second electronic layer 104 are connected by a third ohmic contact 126 at the tip end of each of the plurality of linear regions.

Accordingly, each of the first electronic regions 10 arranged in the X direction (the specific direction) can be electrically connected to the second electronic regions 20 opposed to the first electronic regions 10 in the conduction channel 120 through the third ohmic contact 126.

The light coupling mechanism 110 is configured by a metal thin film provided on the upper side of the upper insulation layer 101 as shown in Fig. 2(a) and Fig. 2(b). The thickness of the metal thin film is approximately 0.1 $\mu$m.

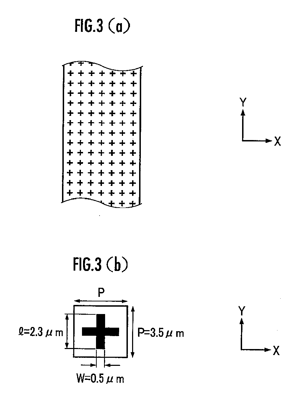

As shown in Fig. 3(a), a plurality of windows which are apart from each other are formed on the metal thin film. The plurality of windows are periodically arranged in a posture having translation symmetry for at least each of the X direction and the Y direction. An array cycle p of the plurality of windows are set to fall within a range of 0.70 to 0.90 ($\lambda$/n) based on a wavelength $\lambda$ of the incident infrared light and a refractive index n of the substrate (the upper insulation layer 101 or the like) including the first electronic layer 102.

For example, the array cycle p of the window is set to be approximately 3.5 $\mu$m (=0.80 $\lambda$') based on the wavelength $\lambda$'= ($\lambda$/n) $\fallingdotseq$ 4.4 $\mu$m of the infrared ray in a substrate (refractive index n$\fallingdotseq$3.34). Here, the array cycle p of the window may be the same or different for each of the X direction and the Y direction if it is in the range of 0.68 to 1.25 ($\lambda$/n).

Each of the windows are formed in a multangular shape in which a part of the internal angles are obtuse angles. For example, as shown in Fig. 3(b), the window (the black portion) is formed in a shape such as two straight line (line segments) having an angle (preferably a right angle) at the four corners crossing each other orthogonally, that is, a cross-like shape. With respect to an array direction of the plurality of windows, a size I of each window is set to be within a range of 0.60 to 0.80 p. For example, a length I of each of a line segment extending in the X direction and a line segment extending in the Y direction configuring the cross is set to be approximately 2.3 $\mu$m (=0.66p). A width w of the line segments is set to be approximately 0.5 $\mu$m.

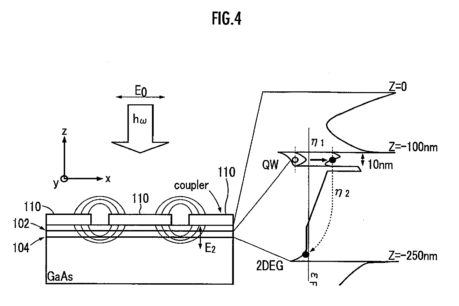

The light coupling mechanism 110 concentrates infrared light photons on the first electronic region 10 and generates an oscillating electric field component Ez perpendicular to the first electronic layer 102. By this, the electrons in the first electronic region 10 are excited to transition from the ground sub-band to the excited sub-band as schematically shown together with the energy state diagram in Fig. 4.

The first gate electrode 111 is formed on the upper side of the first electronic layer 102 (the upper surface of the upper insulation layer 101), such as to traverse each of a plurality of linear regions extending from a belt-like region of the first electronic layer 102. Here, an independent first gate electrode 111 may be provided for each of the plurality of linear regions, and, in addition, the disconnected status and the connected status may be switched separately for each of the plurality of first electronic regions 10.

The first voltage controller 113 applies while adjusting at the same time a bias voltage to the first gate electrode 111. According to the bias voltage applied to the first gate electrode 111, a potential barrier is formed underneath the first gate electrode 111 which electrically disconnects the belt-like region of the first electronic layer 102 and the third ohmic contact 126.

The first gate electrode 111 and the first voltage controller 113 serve as "a status controlling mechanism" which performs switching between a disconnected status and a connected status of the first electronic region 10. "The disconnected status" means a status in which the first electronic region 10 is electrically disconnected from the outer electron system and the electron is limited or prohibited from flowing into the first electronic region 10 from the outer electron system. "The connected status" means a status in which the first electronic region 10 is electrically connected to the outer electron system and the electron is permitted, and not limited or prohibited, to flow into the first electronic region 10 from the outer electron system.

For each of the first electronic region 10, each of the second electronic regions 20 opposed to each of the first electronic regions 10 in the conduction channel 120 is configured as the outer electron system. The outer electron system is configured to satisfy a predetermined condition. "The predetermined condition" is a condition that the electron energy level $\varepsilon_1$ of the excited sub-bands of each of the first electronic regions 10 in the connected status becomes higher with respect to the Fermi level (electrochemical potential) in each of the second electronic regions 20 in the conduction channel 120 to a degree which enables the electrons transitioned to the excited sub-bands of each of the first electronic regions 10 in the disconnected status to (easily or with high probability) flow out to each of the corresponding second electronic regions 20.

In view of the character that there is not so much change in the performance increase even if a size of the first electronic region 10 is selected arbitrarily, and in view of actual preparing conditions or the like, each of the first electronic regions 10 is configured such that the horizontal width thereof (a size in X direction) is within a range of 0.1 to 3.0$\lambda$ and the longitudinal width thereof (a size in the Y direction) is within a range of 0.5 to 10 $\lambda$ ($\lambda$ denotes a vacuum wavelength of the infrared light) . For example, in a case where $\lambda$ = 14.7 $\mu$m, each of the first electronic regions 10 are configured such that the horizontal width thereof is 30 $\mu$m and the longitudinal width thereof is 130 $\mu$m.

Each of the plurality of second gate electrodes 112 are formed on the upper side of the first electronic layer 102(an upper surface of the upper insulation layer 101), and to traverse in the Y direction over the belt-like region extending in the X direction in the first electronic layer 102. It is also acceptable to form each of the second gate electrodes 112 to traverse the belt-like region in a direction inclined with respect to the Y direction on the X-Y plane. The second voltage controller 114 applies while adjusting at the same time a bias voltage to each of the second gate electrodes 112. According to the bias voltage applied to the second gate electrode 112, a potential barrier is formed in a portion right below the second gate electrode 112 to electrically disconnect the first electronic layer 102 in the X direction.

Subsequently, the functions of the infrared light detector with the above-mentioned structure will be described.

By applying a bias voltage $V_{1G}$ to the first gate electrode 111, a potential barrier is formed in the lower region of the first gate electrode 111. Furthermore, by applying a bias voltage $V_{2G}$ to each of the second gate electrodes 112, a potential barrier is formed in the lower region of each of the second gate electrodes 112. A single first electronic region (the isolated two-dimensional electronic region) is formed by the potential barrier formed by a pair of second gate electrodes 112 at the both ends among the five second gate electrodes 112. The single first electronic region is divided into four mutually electrically independent first electronic regions 10 by the potential barrier formed by the three second gate electrodes 112 in the inner side (refer to Fig. 6(a)).

When the infrared light is incident on the infrared light detector 100, an oscillating electrical filed Ez is formed in each of the plurality of first electronic regions 10 in the perpendicular direction (Z direction) by the light coupling mechanism 110 (refer to Fig. 4). As a result, in each of the first electronic regions 10, the electrons are excited, and then escape from the quantum well and flows into the conduction channel 120 as described above (refer to Fig. 5(a)). Then, each of the first electronic regions 10 in the disconnected status and each of the second electronic regions 20 in the conduction channel 120 function as a capacitor sandwiching the interlayer 103 to accumulate positive electric charge in each of the first electronic regions 10. Fig. 6 (a) schematically illustrates that electrons (represented by filled circles) flow out to the conduction channel 120 from the first electronic region 10 as illustrated by the arrows, and positive electric charges (represented by white circles) are accumulated in the first electronic region 10.

According to the increase of amount of positive electric charge $\Delta Q$ in the first electronic region 10, when it becomes to a state in which the energy high-low difference in the interlayer 103 disappears, the increase of the amount of electric charge in the first electronic region 10 stops and saturates (refer to Fig. 5(b)). Fig. 6 (b) schematically illustrates a state in which a number of positive electric charges (represented by white circles) are accumulated in the first electronic region 10 and the amount of electric charge thereof has increased.

Here, the voltage applied to the first gate electrode 111 is lowered before the variation of the electric conductivity of the conduction channel 120 becomes saturated by the first voltage controller 113. Thus, the potential barrier existing between the first electronic region 10 and the third ohmic contact 126 is eliminated, and the first electronic region 10 is switched from the disconnected status to the connected status.

Then, the electrons flow into the first electronic region 10 from the second electronic region 20 as the outer electron system. The electrons couple with the positive electric charges thereby resetting the amount of electric charge of the first electronic region 10 to zero instantly. Fig. 6(c) schematically illustrates that the second electronic region 20 is electrically connected with the first electronic region 10 through the third ohmic contact 126, and the electrons (represented by filled circles) flow into the first electron region 10 as shown by the arrows to couple with the positive electric charges (represented by white circles).

Thereafter, the first electronic regions 10 are switched from the connected status to the disconnected status, and then the variation of the electric conductivity of the conduction channel 120 is repeatedly detected as described above. Thus, by detecting the variation of the electric conductivity of the conduction channel 120 based on the measured value of the ammeter 128, it is able to detect the value of integral of the incident infrared light with high sensitivity.

The present invention is **characterized in that** it is able to switch between the disconnected status and the connected status of each of the first electronic regions 10 by having each of the second electronic regions 20, which are the opposed regions of each of the first electronic regions 10 in the conduction channel 120, as the outer electron system. Therefore, each time it is switched from the disconnected status to the connected status, the Fermi level (electrochemical potential) $\varepsilon_F$ (=level $\varepsilon_0$ of the ground sub-band) of each of the first electronic regions 10 and the Fermi level (electrochemical potential) $\varepsilon_F$ of the second electronic region 20 become equal.

As a result, regarding each of the first electronic regions 10 and each of the second electronic regions 20, the energy diagram returns to a status shown in Fig. 5 (a) from a status shown in Fig. 5(b). That is, the energy level $\varepsilon_1$ of the excited sub-bands of each of the first electronic regions 10 returns to a sufficiently high status which enables the electrons transitioned to the excited sub-bands to flow out to the second electronic layer 104 from the first electronic region 10, easily or with high probability.

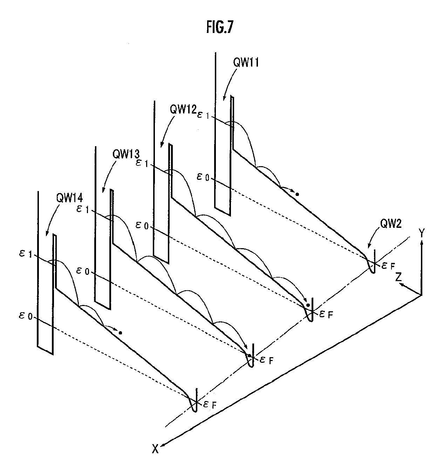

For example, the Fermi level (electrochemical potential) $\varepsilon_F$ (=level $\varepsilon_0$ of ground sub-bands of each of the quantum wells QW11 to QW14) of each of the four electrically independent first electronic regions 10 and the Fermi level (electrochemical potential) $\varepsilon_F$ of each of the second electronic regions 20 become equal, each time it is switched from the disconnected status to the connected status as shown in Fig. 7.

It should be noted that the electron energy level of each of the first electronic regions 10 can be controlled independently, whereas the electron energy level of each of the second electronic regions 20 are controlled uniformly according to a potential gradient in the conduction channel 120.

Accordingly, even if there is a potential gradient (refer to the dashed line) in the X direction (the specific direction) in the conduction channel 120, the high-low difference between the level $\varepsilon_l$ of the excited sub-bands of each of the first electronic regions 10 and the Fermi level (electrochemical potential) $\varepsilon_F$ of each of the second electronic regions 20 is ensured to a degree which enables the electrons transitioned to the excited sub-bands to escape from the first electronic region 10 in the disconnected status easily or with high probability (refer to the arrow of Fig. 7).

Therefore, it is able to escape the electrons from each of the first electronic regions 10 to the conduction channel 120, especially to the second electronic regions 20 easily, while enlarging the potential difference (=source-drain voltage) of the conduction channel 120 for the specific direction (for example, 40 to 50 mV in a case where there are four first electronic regions 10).

In other words, since a single first electronic region (=isolated two-dimensional electronic region) is divided into n number of first electronic regions 10 (n=4 in the present embodiment), the increase of Fermi level (electrochemical potential) $\varepsilon_F$ for each first electronic region 10 is limited to approximately 1/n as shown in Fig. 7. Therefore, the saturated amount of electric charge of each of the first electronic regions 10 becomes $\Delta Q_{sat}=(\varepsilon_1 - U_1 - eV_{SD}/n)C/e$, and from the condition $eV_{SD}/n << \varepsilon_1 - U_1 < hv$, a source-drain voltage $V_{SD}$ of approximately 0.22 * nhv/e, that is, a voltage approximately n times higher compared to that of the single first electronic region before the division, can be applied to the conduction channel 120, and also the signal current and sensitivity increase in proportion thereto.

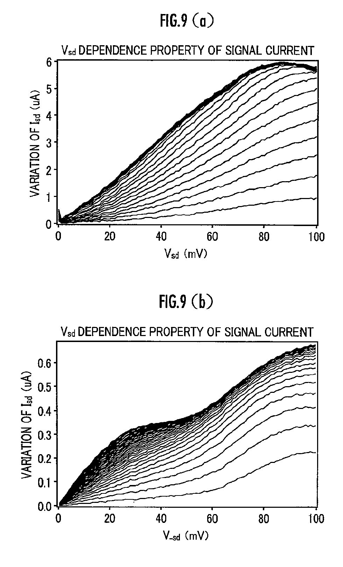

Fig. 9 shows an experimental result regarding the infrared light detecting sensitivity of each of the infrared light detector 100 (refer to Fig. 1) as one embodiment of the present invention in which the single region is divided into n number of first electronic regions 10 (n=4), and a conventional infrared light detector in which the single region is adopted as the single first electronic region.

Fig. 9(a) shows measurement results of dependence property of a source-drain current $I_{sd}$ with respect to a source-drain voltage $V_{sd}$ in the infrared light detector 100 (embodiment). Fig. 9(b) shows measurement results of dependence property of the source-drain current $I_{sd}$ with respect to the source-drain voltage $V_{sd}$ in the infrared light detector (comparative example). Each of the plurality of curved lines indicated in Fig. 9(a) and Fig. 9(b) expresses measurement results at each of a plurality of different time points during the elapsed time 0.25 ms to 10 ms from the reset (refer to Fig. 6(c)) by every 0.25 ms in order from the lowest.

As clear from Fig. 9(b), according to the infrared light detector (comparative example), the current signal $I_{sd}$ saturates at approximately $V_{sd}=20$ mV under all conditions. Therefore, it is only able to apply source-drain voltage $V_{sd}$ up to approximately 20 mV. Here, the increase of current signal $I_{sd}$ in the region equal to or above $V_{sd}=50$ mV is due to a mechanism different from an optical response signal. A similar measurement result is obtained in a case where the size of the single first electronic region 10 is enlarged.

On the other hand, as clear from Fig. 9(a), according to the infrared light detector 100 (embodiment), the current signal $I_{sd}$ linearly increases to approximately $V_{sd}=80$ mV under all conditions. Therefore, it is able to apply a source-drain voltage $V_{sd}$ of approximately 80 mV. That is, according to the infrared light detector 100 (embodiment), the infrared light detection sensitivity is increased approximately x times (x=4) compared to the conventional infrared light detector (comparative example).

(Experiment result 1 regarding the function of the light coupling mechanism)

In order to confirm the function of the light coupling mechanism 110, the quantum efficiency $\eta$ of the infrared light detector 100 was measured. Although the experiment was conducted at 4.2 K, it is confirmed that the infrared light detector 100 of the present invention is able to sufficiently demonstrate its light detecting function at an arbitrary temperature equal to or less than 23 K. A substrate with a first electronic layer 102 whose electron density $n_1 = 3.2 \times 10^{15}$ $m^{-2}$ and its mobility $\mu_1 = 1.4$ $m^2$ /Vs, and a second electronic layer 104 whose electron density $n_2 = 3.9 \times 10^{15}$ $m^{-2}$ and its mobility $\mu_2 = 4.4$ $m^2$ /Vs, was used in the experiment.

The quantum efficiency $\eta$ of the infrared light detector 100 is expressed by the relational expression (02) by using a source-drain current $I_{sd}$, a variation of current amount $\Delta I_e$ between the source-drain according to an absorption of one photon, and a photon flux density $\Phi$.

$$\eta = (\partial I_{sd}/\partial t)/(\Phi \Delta I_e) \quad ..(02).$$

A photon flux density $\Phi$ is expressed by relational expression (04) as a function of absolute temperature T by using an emissivity $\varepsilon$ of a radiator, rate of decrease f through the GaAs window, emission solid angle $\Omega = A_{det}/d^2$ ($A_{det}$: area of the detector, d: interval between the radiator and the detector), emission area $A_{em}$, and the band width $\Delta\lambda$ of the detector 100.

$$\Phi(T) = \varepsilon f \Omega \Delta\lambda B(\lambda,\ T) A_{em} /(hc/\lambda) \quad ..(04).$$

Here, $B(\lambda, T)$ expresses a relational expression (06) of a Planck radiation of black body.

$$B(\lambda,\ T) = (2hc^2/\lambda^5)(\exp\{hc/\lambda k_B T\} - 1)^{-1} \quad ..(06).$$

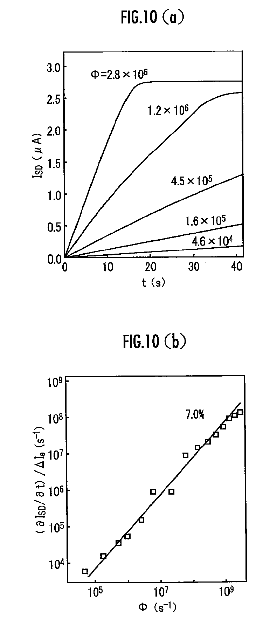

Fig. 10(a) shows a measurement result of source-drain current $I_{sd}$ in each case where the photon flux density $\Phi$ in the first electronic region 10 is different. It is found that a time rate of change $(\partial I_{sd}/\partial t)$ of the source-drain current becomes higher, that is, the inclination of the approximated curve of the series of the measurement points in a t-$I_{sd}$ plane becomes larger, as the photon flux density $\Phi$ becomes higher.

Fig. 10 (b) shows a measurement result of the photon flux density $\Phi$ in the first electronic region 10 and an electron outflow rate $E = (\partial I_{sd}/\partial t)/\Delta I_e$ from the first electronic region 10 to the conduction channel 120 or the like. As clear from the relational expression (02), the inclination of the curve expressing the series of the measurement points in the $\Phi$ -$(\partial I_{sd}/\partial t)/\Delta I_e$ plane indicates the quantum efficiency $\eta$. As a result, it is found that the quantum efficiency $\eta$ is 7.0%.

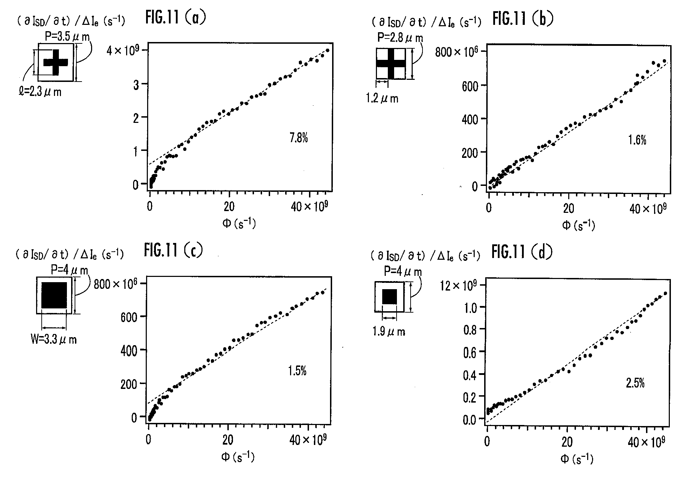

Fig. 11 shows a measurement result of the photon flux density $\Phi$ in the first electronic region 10 and the electron outflow rate $E = (\partial Isd/\partial t)/\Delta Ie$ from the first electronic region to the conduction channel 120 regarding a infrared light detector 100 using another substrate.

(Embodiment 1) Fig. 11(a) expresses the experiment results in a case where the light coupling mechanism 110 shown in Fig. 3 (a) and Fig. 3(b) is formed. In this case, the quantum efficiency $\eta$ was 7.8%.

(Comparative example 1) Fig. 11(b) expresses the experiment results in a case where the light coupling mechanism 110 is formed by a metal thin film in which cross-like shaped windows configured by line segments having a length of $1=2.8$ $\mu$m (=1.0 p) and a width of w=0.5 $\mu$m which cross each other orthogonally at center portions, are arranged sequential to each other by a cycle of p=2. 8 $\mu$m (=0.53 $\lambda$') in each of the X direction and the Y direction. In this case, the quantum efficiency $\eta$ was 1.6%.

(Comparative example 2) Fig. 11(c) expresses the experiment results in a case where the light coupling mechanism 110 is formed by a metal thin film in which squared shaped windows with each sides having a length of w=3.3 $\mu$m (=0.83 p), are arranged apart from each other by a cycle of p=4.0 $\mu$m (=0.91 $\lambda$') in each of the X direction and the Y direction. In this case, the quantum efficiency $\eta$ was 1.5%.

(Comparative example 3) Fig. 11(d) expresses the experiment results in a case where the light coupling mechanism 110 is formed by a metal thin film in which squared shaped windows with each sides having a length of w=1.9 $\mu$m (=0.48 p), are arranged apart from each other by a cycle of p=4.0 $\mu$m (= 0.91 $\lambda$') in each of the X direction and the Y direction. In this case, the quantum efficiency $\eta$ was 2.5%.

From the above experiment results, it is found that the light coupling mechanism 110 of embodiment 1 significantly improves the quantum efficiency compared to comparative examples 1 to 3.

(Experiment result 2 regarding the function of the light coupling mechanism)

The quantum efficiency $\eta$ of the infrared light detector 100 is expressed by relational expression (08) by using a first factor $\eta_1$ indicating a ratio of photons which transitioned the electrons in the first electronic layer 102 between the sub-bands among the photons irradiated to the infrared light detector 100 and a second factor $\eta_2$ indicating a ratio of electrons which reached the second electronic layer 104 among the electrons transitioned between the sub-bands in the first electronic layer 102 (refer to Fig. 4).

$$\eta = \eta_1 \cdot \eta_2 \ .. (08).$$

The quantum efficiency $\eta$ was measured for each of the infrared light detectors 100 having different array cycle p under a common condition that a cross-like shape is used as the window shape, and the array cycle p of the window as a reference, the length I of the line segment constituting the cross is I=0.6 p and the width w of the line segment is w = 0.12 p.

Each of the six different cycles 3.0, 3. 5, 4.0, 4.5, 5.0, and 5.5 $\mu$m (= 0.68$\lambda$', 0.80$\lambda$', 0.91$\lambda$', 1.02$\lambda$', 1.13$\lambda$', and 1.25$\lambda$') was used as the array cycle p of the window. Furthermore, the wavelength in a vacuum is $\lambda$ = 14.7 $\mu$m and an infrared ray having a wavelength $\lambda$' = ($\lambda$/n) = 4.4 $\mu$m in the substrate was used.

Two substrates having different physicality was used as the substrate constituting the infrared light detector 100. As the first substrate, a substrate with a first electronic layer 102 whose electron density $n_2$ = 3.2 $\times 10^{15}$ m$^{-2}$ and its mobility $\mu_1$ =1.4 m$^2$/Vs, and a second electronic layer 104 whose electron density $n_2$ = 3.9 $\times 10^{15}$ m$^{-2}$ and its mobility $\mu_2$ = 4. 4 m$^2$ /Vs was used. As the second substrate, a substrate with a first electronic layer 102 whose electron density $n_1$ = 2.9 $\times 10^{15}$ m$^{-2}$ and its mobility $\mu_1$= 6.5 m$^2$ /Vs, and a second electronic layer (GaAs layer) 104 whose electron density $n_2$ = 4.1 $\times 10^{15}$ m$^{-2}$ and its mobility $\mu_2$ = 7.7 m$^2$ /Vs was used.

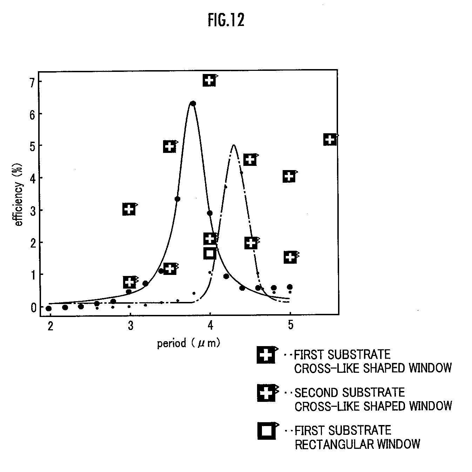

Fig. 12 shows a measurement result of the quantum efficiency $\eta$ of the infrared light detector 100 using each of the first substrate and the second substrate.

The quantum efficiency $\eta$ of the infrared light detector 100 using the first substrate was 3.1%, 5.0%, 7.0%, 4.5%, 4.0%, and 5.1% for each of the six different window array cycle p.

The quantum efficiency $\eta$ of the infrared light detector 100 using the second substrate was 0.8%, 1.1%, 2.0%, 1.8%, and 1.3% for each of the five different window array cycles p = 3.0, 3.5, 4.0, 4.5, and 5.0 $\mu$m.

For reference, the quantum efficiency $\eta$ was 1.5% in a case where the first substrate was used and the light coupling mechanism 110 was formed by a metal thin film in which squared shaped windows with each sides having a length of w=2.0 $\mu$m (=0.50 p) and arranged apart from each other by a cycle of p=4.0 $\mu$m (=0.91 $\lambda$') in each of the X direction and the Y direction.

It is considered that the difference of the quantum efficiency $\eta$ according to the difference of using the first substrate or the second substrate is due to the difference of the second factor $\eta_2$ (refer to the relational expression (08)).

The solid line of Fig. 12 indicates a simulation result of the quantum efficiency $\eta$ in a case where the window shape is a cross-like shape. The dashed line of Fig. 12 indicates a simulation result of the quantum efficiency $\eta$ in a case where the window shape is a rectangular shape. From Fig. 12, the quantum efficiency $\eta$ shows a peak at p = 3.8 $\mu$m according to the simulation, whereas the quantum efficiency $\eta$ shows a peak in the vicinity of p = 4 $\mu$m according to the experiment.

The simulation was performed under the condition that a gold layer having a thickness of 100 nm was formed on the upper surface of the GaAs substrate having a thickness of 5 $\mu$m and a refraction index n = 3.34. The existence of AlGaAs/GaAs layer constituting the first electronic layer 102 and the second electronic layer 104 was ignored.

In a case where an electric field where the incident light oscillates in the X direction is expressed by E(z, t)= [$E_o$ exp(i(-kz+$\omega$t)),0,0], the z component of the electric field $E_z$ (x, y)exp(i$\omega$t) in z=-100 nm where the first electronic region 10 exists, was calculated. The calculation was done upon applying a boundary condition in view of the periodical alignment of the windows. Thereafter, $<E_z^2>/E_o^2$ was calculated. $<E_z^2>$ denotes a mean square value of the z component of the electric field $E_z$(x, y) in the x-y plane of z=-100 nm.

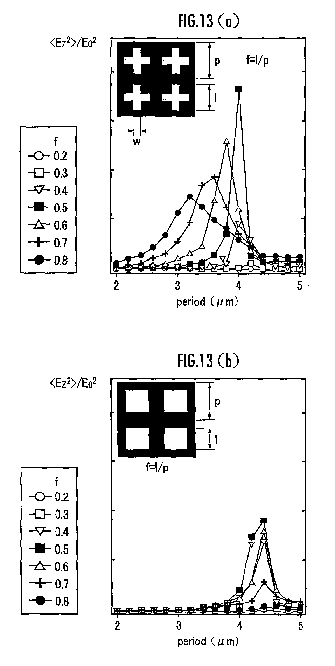

Fig. 13(a) shows calculation results of $<E_z^2>/E_o^2$ in a plurality of cases where f=I/p of the cross shaped windows differ. Fig. 13 (b) shows calculation results of $<E_z^2>/E_o^2$ in a plurality of cases where f=I/p of the rectangular windows differ. Especially, as seen from Fig. 13(a), regarding cross shaped windows, there are cases where an amplitude $|E_z|$ of the electric field z component in the first electronic region 10 becomes larger than an amplitude $|E_o|$of the electric field of the incident light.

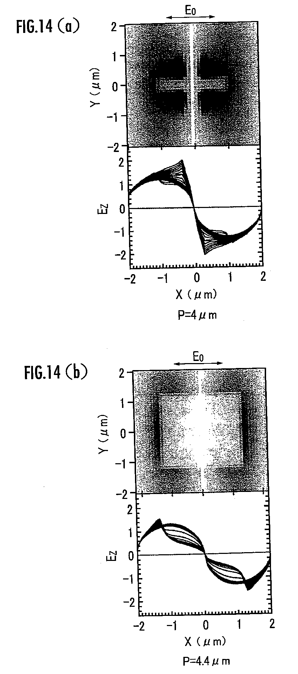

Fig. 14(a) shows calculation results of the electric field z component $E_z$(x, y) in a plurality of positions of the first electronic region 10, in a cases where the window is a cross shape and the array cycle p of the window is p=4.0 µm and f=0.5. Fig. 14(b) shows calculation results of the electric field z component $E_z(x, y)$ in a plurality of positions of the first electronic region 10, in a cases where the window is a square and the array cycle p of the window is p=4.4 µm and f=0.5. The portions having high cardinality in Fig. 14 indicate portions where the amplitude $|E_z|$ of the electric field z component is large. As can be seen from Fig. 14, the portion having large electric field z component $E_z$ in the first electronic region 10 is concentrated regionally.

The first factor $\eta_1$ is proportional to a transition probability $W_{10}$ of the electrons between the sub-bands in the first electronic region 10, and the probability $W_{10}$ is proportional to square of amplitude $|E_z|$ of the electric field z component in the first electronic layer 102. Therefore, the quantum efficiency $\eta$ becomes high as the amplitude $|E_z|$ of the electric field z component becomes large.

The first factor $\eta_1$ is expressed by relational expression (10) by using electron density $n_1$ of the first electronic region 10, Dirac constant $h_{bar}$, energy difference $\omega_{10}$ between the sub-bands, effective mass $m^*$ of the electron, and oscillator strength $f_{10}$.

$$\eta_1 = [n_1 h_{bar} \omega_{10} / (2m^* \omega^2 c \varepsilon_0)] f_{10} / \{ (h_{bar} \omega_{10} - h_{bar} \omega)^2 + \Gamma^2 \} \times [<E_z^2> / E_0^2] .. (10).$$

(Alternative embodiment of the present invention)

Although, in the above embodiment, each of the second electronic regions 20 in the conduction channel 120 was adopted as the outer electron system of each of the first electronic regions 10, it is acceptable to adopt all kinds of outer electron systems which satisfy the predetermined condition as alternative embodiments. For example, with respect to each of the first electronic regions 10, a region having higher potential than each of the second electronic regions 20 in the conduction channel 120, or the first ohmic contact 122 may be used as the outer electron system. Moreover, with respect to each of the first electronic regions 10, a region having lower potential than each of the second electronic regions 20 in the conduction channel 120 may be used as the outer electron system.

Although, outer electron system having different Fermi level was used for each of the first electronic regions 10 in the present embodiment, it is acceptable to use an outer electron system having a common Fermi level for 2 or more first electronic regions 10 as an alternative embodiment. For example, it is acceptable to use one second electronic region 20 on the highest potential side in the conduction channel 120 as the outer electron system for each of the first electronic regions 10.

The antenna 110 of the present invention may be applied to various high sensitivity infrared light detectors comprising a CSIP as an element such as the infrared light detector of published PCT international application WO2006/006469A (Patent Document 1) or the infrared light detector of Japanese patent laid-open publication number 2008-205106 (Patent Document 2) or the like.

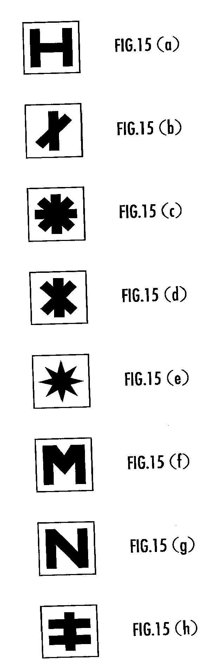

Besides the cross-like shaped window as shown in Fig. 3(b), the window can be formed in various multangular shapes in which a part of the internal angles are obtuse angles as shown in each of Fig. 15(a) to Fig. 15(h).

**Claims**

1. An infrared light detector, comprising:

   a first electronic region configured to be capable of being maintained in an electrically isolated status in a first electronic layer which is a two-dimensional electronic layer;
   a light coupling mechanism configured to excite an electron by generating an oscillating electric field component perpendicular to the first electronic region according to an incident infrared light, and allowing the electron to transit between sub-bands in a quantum well formed in the first electronic region;
   a conduction channel in a second electronic layer which is a two-dimensional electronic layer disposed parallel to the first electronic layer via an intermediate insulation layer, whose electric conductivity varies as a result of the electron excited by the light coupling mechanism flowing out of the first electronic region;
   a status controlling mechanism configured to perform switching between a disconnected status in which the first electronic region is electrically disconnected from an outer electron system and a connected status in which the first electronic region is electrically connected to the outer electron system; and
   which detects the incident infrared light by detecting a variation of the electric conductivity with respect to a specific direction of the conduction channel,
   wherein the light coupling mechanism is composed of a metal thin film or a metal thin plate on which a plurality of windows apart from each other are formed, the plurality of windows being arrayed periodically in a posture having translational symmetry for at least two directions, and

wherein an array cycle p of the plurality of windows is set according to a wavelength $\lambda'$ of the incident infrared light of a substrate including the first electronic layer so as to fall within a first specific range with reference to a value at which the perpendicular oscillating electric field component in the first electronic region indicates a peak.

2.  The infrared light detector according to claim 1, wherein the first specific range is 0.68 to 1.25 $\lambda'$.

3.  The infrared light detector according to claim 2, wherein the first specific range is 0.80 to 1.02 $\lambda'$.

4.  The infrared light detector according to claim 1, wherein with respect to an array direction of the plurality of windows, a size l of each window is set according to the array cycle p of the plurality of windows so as to fall within a second specific range with reference to a value at which the perpendicular oscillating electric field component in the first electronic region indicates a peak.

5.  The infrared light detector according to claim 4, wherein the second specific range is 0.50 to 0.80 p.

6.  The infrared light detector according to claim 1, wherein each of the windows is formed in a multangular shape in which a part of internal angles are obtuse angles.

7.  The infrared light detector according to claim 6, wherein each of the plurality of windows are formed in a shape such as a plurality of line segments having an angle at four corners crossing each other.

8.  The infrared light detector according to claim 7, wherein each of the plurality of windows are formed in a cross-like shape such as two of the plurality of line segments having an angle at four corners crossing orthogonally.

FIG.1

FIG.2 (a)

FIG.2 (b)

FIG.3 (a)

Y
X

FIG.3 (b)

P

ℓ=2.3 μm

P=3.5 μm

W=0.5 μm

Y
X

FIG.4

FIG.5 (a)

FIG.5 (b)

FIG.6 (a)

FIG.6 (b)

FIG.6 (c)

FIG.7

FIG.8

FIG.9 (a)

FIG.9 (b)

FIG.10 (a)

FIG.10 (b)

FIG.11 (a)

$(\partial I_{SD}/\partial t)/\Delta I_e$ (s$^{-1}$)

P=3.5 $\mu$ m

$\ell$=2.3 $\mu$ m

7.8%

$\Phi$ (s$^{-1}$)

FIG.11 (b)

$(\partial I_{SD}/\partial t)/\Delta I_e$ (s$^{-1}$)

P=2.8 $\mu$ m

1.2 $\mu$ m

1.6%

$\Phi$ (s$^{-1}$)

FIG.11 (c)

$(\partial I_{SD}/\partial t)/\Delta I_e$ (s$^{-1}$)

P=4 $\mu$ m

W=3.3 $\mu$ m

1.5%

$\Phi$ (s$^{-1}$)

FIG.11 (d)

$(\partial I_{SD}/\partial t)/\Delta I_e$ (s$^{-1}$)

P=4 $\mu$ m

1.9 $\mu$ m

2.5%

$\Phi$ (s$^{-1}$)

FIG.12

· ·FIRST SUBSTRATE
CROSS-LIKE SHAPED WINDOW

· ·SECOND SUBSTRATE
CROSS-LIKE SHAPED WINDOW

· ·FIRST SUBSTRATE
RECTANGULAR WINDOW

## FIG.13 (a)

$\langle E_z{}^2 \rangle / E_0{}^2$

f=l/p

f

-O- 0.2
-□- 0.3
-▽- 0.4
-■- 0.5
-△- 0.6
-+- 0.7
-●- 0.8

period (μm)

## FIG.13 (b)

$\langle E_z{}^2 \rangle / E_0{}^2$

f=l/p

f

-O- 0.2
-□- 0.3
-▽- 0.4
-■- 0.5
-△- 0.6
-+- 0.7
-●- 0.8

period (μm)

FIG.14 (a)

$E_0$

Y ($\mu$m)

$E_z$

X ($\mu$m)

P=4$\mu$m

FIG.14 (b)

$E_0$

Y ($\mu$m)

$E_z$

X ($\mu$m)

P=4.4$\mu$m

FIG.15 (a)

FIG.15 (b)

FIG.15 (c)

FIG.15 (d)

FIG.15 (e)

FIG.15 (f)

FIG.15 (g)

FIG.15 (h)

### INTERNATIONAL SEARCH REPORT

| International application No. |
| --- |
| PCT/JP2010/056865 |

A. CLASSIFICATION OF SUBJECT MATTER
*H01L31/10*(2006.01)i, *H01L31/0264*(2006.01)i

According to International Patent Classification (IPC) or to both national classification and IPC

B. FIELDS SEARCHED

Minimum documentation searched (classification system followed by classification symbols)
H01L31/10, H01L31/0264

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | Z.AN et al., Reset Operation of Quantum-Well Infrared Phototransistors, IEEE Transactions on Electron Devices, 2007.07, vol.54, no.7, p.1776-1780 | 1-8 |
| A | Z.AN et al., A sensitive double quantum well infrared phototransistor, Journal of Applied Physics, 2006, 100, p.044509 | 1-8 |
| A | WO 2008/102630 A1 (Japan Science and Technology Agency), 28 August 2008 (28.08.2008), entire text; all drawings & JP 2008-205106 A | 1-8 |

☒ Further documents are listed in the continuation of Box C. ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>11 June, 2010 (11.06.10) | Date of mailing of the international search report<br>22 June, 2010 (22.06.10) |
| --- | --- |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
|---|
| PCT/JP2010/056865 |

C (Continuation).   DOCUMENTS CONSIDERED TO BE RELEVANT

| Category* | Citation of document, with indication, where appropriate, of the relevant passages | Relevant to claim No. |
|---|---|---|
| A | WO 2006/006469 A1  (Japan Science and Technology Agency), 19 January 2006 (19.01.2006), entire text; all drawings & JP 4281094 B        & US 2007/0215860 A1 & EP 1788637 A1 | 1-8 |
| A | JP 2008-506269 A  (Ion Optics, Inc.), 28 February 2008 (28.02.2008), entire text; all drawings & US 2007/0018077 A1     & US 2007/0034978 A1 & WO 2006/010133 A2     & WO 2006/007446 A2 & CA 2573149 A           & CA 2573928 A | 1-8 |
| A | JP 2007-531277 A  (Research Foundation of the City University of New York), 01 November 2007 (01.11.2007), entire text; all drawings & US 2007/0235635 A1    & WO 2005/092037 A2 & CA 2564686 A | 1-8 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006006469A A

- JP 2008205106 A

**Non-patent literature cited in the description**

- **An et al.** Infrared phototransistor using capacitively coupled two-dimensional electron gas layers. *Appl. Phys. Lett.,* 2005, vol. 86, 172106
- **An et al.** A sensitive double quantum well infrared photoresistor. *J. Appl. Phys.,* 2006, vol. 100, 044509

- **zhenghua An ; TakejiUeda ; Kazuhiko Hirakawa ; Susumu Komiyama.** Reset Operation of Quantum-Well Infrared Phototransistor. *IEEE Transactions on Electron Devices,* 2007, vol. 54, 1776-1780